# EUROPEAN PATENT SPECIFICATION

(11) **EP 2 732 470 B1**
(45) Date of publication and mention of the grant of the patent: **16.05.2018**
(21) Application number: 12761752.0
(22) Date of filing: 13.07.2012
(51) Int. Cl.: H01L 27/32, H01L 27/142, B23K 26/36

(54) **METHOD AND APPARATUS FOR DIVIDING THIN FILM DEVICE INTO SEPARATE CELLS**
VERFAHREN UND VORRICHTUNG ZUR UNTERTEILUNG EINES DÜNNSCHICHTELEMENTS IN GETRENNTE ZELLEN
PROCÉDÉ ET APPAREIL DE DIVISION DE DISPOSITIF DE COUCHE MINCE EN CELLULES SÉPARÉES

(30) Priority: 15.07.2011 GB 201112285
(43) Date of publication of application: 21.05.2014
(73) Proprietor: M-Solv Limited, Oxford OX5 1FP (GB)
(72) Inventor: BRUNTON, Adam North, Eynsham Oxford OX29 4HG (GB)
(74) Representative: J A Kemp
(86) International application number: PCT/GB2012/000591
(87) International publication number: WO 2013/011255

(56) References cited:
- EP-A1- 2 320 474
- WO-A1-2011/004509
- WO-A1-2011/048352
- US-A1- 2011 312 158

## Description

### TECHNICAL FIELD

This invention relates to a process of using scribing and ink jet printing techniques for forming separate electrical cells and interconnecting them in series to manufacture various thin film devices. In particular, it describes a novel method for forming the cells and series interconnecting structures in a single step process in solar panels that have continuous layers of bottom electrode material, semiconductor material and top electrode material. It is particularly appropriate for solar panels formed on flexible substrates as the single step process eliminates the problems associated with sequential layer to layer scribe alignment. The method is also appropriate for the manufacture of other thin film devices such as lighting panels and batteries. The invention also relates to apparatus for carrying out the method described.

### BACKGROUND ART

The usual way to form and interconnect cells in thin film solar panels involves sequential layer coating and laser scribing processes. To complete the structure three separate coating processes and three separate laser processes are usually required. It is usual to perform these processes in a six step sequence consisting of a laser step following each coating step as described below:-
a) Deposit a thin layer of the lower electrode material over the whole substrate surface. The substrate is usually glass but can also be a polymer sheet. This lower layer is often a transparent conducting oxide such as tin oxide (SnO2), zinc oxide (ZnO) or indium tin oxide (ITO). Sometimes it is an opaque metal such as molybdenum (Mo).
b) Laser scribe parallel lines across the panel surface at typically 5-10mm intervals right through the lower electrode layer to separate the continuous film into electrically isolated cell regions.
c) Deposit the active electricity generating layer over the whole substrate area. This layer might consist of a single amorphous silicon layer or a double layer of amorphous silicon and micro-crystalline silicon. Layers of other semiconducting materials such as cadmium telluride and cadmium sulphide (CdTe/CdS) and copper indium gallium di-selenide (CIGS) are also used.
d) Laser scribe lines through this active layer or layers parallel to and as close as possible to the initial scribes in the first electrode layer without damaging the lower electrode material.
e) Deposit a third, top electrode layer, often a metal such as aluminium or a transparent conductor such as ZnO, over the whole panel area.
f) Laser scribe lines in this third layer as close to and parallel to the other lines to break the electrical continuity of the top electrode layer.

This procedure of deposition followed by laser isolation breaks up the panel into a multiplicity of separate long, narrow cells and causes an electrical series connection to be made between all the cells in the panel. In this way the voltage generated by the whole panel is given by the product of the potential formed within each cell and the number of cells. Panels are divided up into typically 50-100 cells so that overall panel output voltage is typically in the 50 to 100 Volt range. Each cell is typically 5-15 mm wide and around 1000mm long. A thorough description of the processes used in this multi-step solar panel manufacturing method is given in JP10209475.

Schemes have been devised to simplify this multi step process of making solar panels by combining some of the separate layer coating steps. This reduces the number of times the substrate has to be moved from a vacuum to an atmospheric environment and hence is likely to lead to improved layer quality and increased solar panel efficiency. US6919530, US6310281 and US2003/0213974A1 all describe methods for making solar panels where two of the 3 required layers are coated before laser scribing is performed. The lower electrode layer and the active layer (or layers) are deposited sequentially and then both layers are laser scribed together to form a groove that is then filled with an insulating material. For US6310281 and US2003/0213974A1 it is proposed that this groove filling be performed by ink jet printing. Following the groove filling, the interconnection procedure is as described above with a laser scribe through the active layer, deposition of the top electrode layer and a final scribe of the top electrode layer to isolate the cells.

A scheme has also been proposed where all three layers are coated before any laser scribing is performed. WO 2007/044555 A2 describes a method for making a solar panel where the complete three layer stack is coated in one process sequence following which laser scribes are made into and through the stack. The laser scribe process is complex as it consists of a single scribe with two different depths. On a first side of the scribe the laser penetrates the complete three layer stack right through to the substrate in order to electrically separate the lower electrode layer to define the cells while on the second side of the scribe the laser only penetrates through the top and active layers to leave a region where a ledge of lower electrode layer material is exposed. Insulating material is applied locally to the first side of the scribe that penetrates to the substrate so that the insulating material covers the edge of the lower electrode layer and the edge of the active layer on the first side of the scribe. Following this, conducting material is deposited into the scribe so that it bridges the insulating material previously applied and connects the top electrode layer on the first side to the ledge of lower electrode material on the second side.

The process described in WO2007/044555A2 is complex and requires careful control. Debris generated during the second stage of the dual level laser scribe process is likely to deposit on the adjacent top surface of the ledge of lower electrode material leading to poor electrical connection. A high level of control is needed to ensure that the insulating material is placed in exactly the right position on the first side of the scribe and no material is deposited on top of the ledge of lower electrode material. Extreme accuracy is needed to ensure that the conducting material is placed correctly and does not contact the top electrode on the second side of the scribe. For all these reasons it is unlikely that cell connections can be made with high reliability by this method.

Hence, there remains a requirement for a new cell formation and interconnection process for solar panels and the like that starts with the full stack of three layers but proceeds to make the cell interconnections in a way that is fast, simple and reliable.

Such a process will also be applicable to the formation and series interconnection of cells for the manufacture of other thin film devices such as lighting panels or batteries. Like solar panels, such devices consist of a lower electrode layer, an active layer and a top electrode layer all deposited on a rigid or flexible substrate. Operation at voltages higher than the fundamental single cell voltage can be achieved by dividing the device into multiple cells and connecting the cells in series. The laser and ink jet cell formation and interconnection apparatus proposed here is suitable for such an operation.

For lighting panels, the upper and lower electrodes are likely to be of similar materials to those used for solar panels (eg TCOs or metals) but the active materials are very different. In this case, active layers are most likely to be organic materials but inorganic materials are also possible. Active organic layers are either based on low molecular weight materials (so called OLEDs) or high molecular weight polymers (so called P-OLEDs). Hole and electron transport layers are usually associated with the active light emitting layers. For these lighting panels, operation is at low voltage and all layers are thin and hence the interconnection process described herein is ideal for dividing the panel into cells and connecting these in series to allow operation at a substantially higher voltage.

For thin film batteries the layers are often more complex. For the case of a thin film battery based on Lithium ion technology, the lower layer has two components - a metal layer for current collection and a Lithium Cobalt Oxide (LiCoO3) layer that functions as a cathode. The upper layer also has two components - a metal layer for current collection and a Tin Nitride (Sn3N4) layer that functions as an anode. In between these two layers is the active layer - a Lithium Phosphorous OxyNitride (LiPON) electrolyte. For such batteries, operation is at low voltage and all layers are thin and hence the interconnection process described herein is ideal for dividing the battery into cells and connecting these in series to allow operation at a substantially higher voltage.

The applicants have proposed a method and apparatus for dividing a thin film device into separate cells in a single combined process in which all the cutting processes and ink-jet based deposition processes are performed by means of the movement of a process head in a single pass across the device. This is described in WO2011/048352 and the teaching thereof is incorporated herein. The present invention relates to a modification of this method and apparatus which provides greater flexibility in the way the process steps are carried out in the single pass.

### SUMMARY OF THE INVENTION

According to a first aspect of the invention, there is provided a method for dividing a thin film device having a first layer which is a lower electrode layer, a second layer which is an active layer and a third layer which is an upper electrode layer, all the layers being continuous over the device, into separate cells which are electrically interconnected in series, the dividing of the cells and the electrical connection between adjacent cells all being carried out in a single pass of a process head across the device, the process head comprising a first part positioned above the device and a second part positioned beneath the device, the first and second parts of the process head together performing the following steps in the single pass:
a) making a first cut through the first, second and third layers;
b) making a second cut through the second and third layers, the second cut being adjacent to the first cut;
c) making a third cut through the third layer the third cut being adjacent to the second cut and on the opposite side of the second cut to the first cut;
d) using a first ink jet print head on the first part of the process head to deposit a non-conducting material into the first cut; and
e) using a second ink jet print head on the first part of the process head to apply conducting material to bridge the non-conducting material in the first cut and either fully or partially fill the second cut such that an electrical connection is made between the first layer and the third layer,
wherein step (a) precedes step (d), step (d) precedes step (e) and step (b) precedes step (e), otherwise the steps may be carried out in any order in the single pass of the process head across the device and wherein at least one of the first, second or third cuts is formed using a laser beam directed from the second part of the process head towards said first, second and third layers from the underside of the device.

According to a second aspect of the invention, there is provided apparatus for dividing a thin film device having a first layer which is a lower electrode layer, a second layer which is an active layer and a third layer which is an upper electrode layer, all the layers being continuous over the device, into separate cells which are electrically interconnected in series, the apparatus comprising a process head having a first part arranged to be positioned above the device and a second part arranged to be positioned beneath the device, the first and second parts of the process head together being provided with:
f) one or more cutter units for making a first cut though the first, second and third layers, a second cut though the second and third layers adjacent to the first cut and a third cut through the third layer adjacent to the second cut and on the opposite side of the second cut to the first cut;
g) a first ink jet print head for depositing a non-conducting material into the first cut; and
h) a second ink jet print head for applying conducting material to bridge the non-conducting material in the first cut and either fully or partially fill the second cut so that an electrical connection is made between the first layer and the third layer,
   the apparatus also comprising:
i) drive means for moving the process head relative to the device; and
e) control means for controlling movement of the process head relative to the device and actuating said one or more cutter units and said first and second ink jet print heads so that division of the device into separate cells and the formation of an electrical connection between adjacent cells can all be carried out in a single pass of the process head across the device, wherein the first and second ink jet print heads are provided on the first part of the process head and arranged to apply material to an upper side of the device and the or one of the cutter units is provided on the second part of the process head and arranged to form at least one of the first, second or first cuts by means of a laser beam directed therefrom towards said first, second and third layers from the underside of the device.

Terms such as above and beneath, upperside and underside as used herein are to be understood to be refer to the relative positions of the opposite sides of a planar device (as it if were orientated with said layers provided on the upper side thereof) and are not restricted to the orientation of said device in space. In practice, the device may be in any orientation and examples are given of it being both horizontal and vertical relative to gravity.

In the detailed description of the invention that follows the cutter units that are used to form the cuts through the various layers are all based on lasers, the beams from which are focussed to ablate and remove material to form the isolating cuts. This is the preferred method for forming the cuts but other methods of cutting may also be used. One alternative method for forming cuts is mechanical scribing with fine wires or styli. Such mechanical scribing can be used instead of laser cutting for forming all or some of the first, second or third cuts - except those that are formed from the underside of the device.

Like the invention described in WO 2007/044555 A2, this invention involves the processing of a thin film device having a complete stack of three layers but subsequent layer cutting and ink jet processing is less complex and much more robust compared to that described in WO 2007/044555 A2. As in WO2007/044555 A2, all three coatings are applied sequentially before any layer cutting or material deposition by ink jetting. Ideally, these coatings might be applied in a single vacuum process but this is not essential.

As indicated above, a key point of the invention is that following the deposition of the coatings a single combined layer cutting and ink jet process is used to make the cell inter-connections. A "single combined process" means that all the cutting processes and all the associated ink jet based material deposition processes are performed by means of the movement of a process head in a single pass across all or part of the solar panel in a plane parallel to the substrate surface and in a direction parallel to the boundary between the cells. All cutter units and all ink jet print heads required to make one or more cell interconnections are attached to either the first part or second part of the process head and hence all items move together at the same speed across the panel and all processes are carried out in a single pass of the head.

The sequence in which the various layer cutting processes and the various ink jet deposition processes are applied to the substrate can vary depending on the materials used. The various layer cutter units and ink jet print heads are attached to the first and second parts of the process head in such positions that the correct sequence is achieved as the process head moves with respect to the substrate.

For simplicity of illustration, the layer cutting processes will henceforth be described with reference to laser ablation. It should be noted, however, that all or some of these laser cutting processes may be replaced by a mechanical scribing process (or other cutting process) - except those carried out from the underside of the device.

WO 2011/048352 describes a method and apparatus for dividing a thin film solar panel into separate cells and connecting these cells electrically in series. The apparatus uses a process head that supplies three laser beams delivered by suitable optics as well as insulating and conducting inks delivered by two or more nozzles. All of these components are mounted on a process head that addresses a single interconnect structure between two adjacent cells so that a single passage of the head across the solar panel creates one single interconnect structure.

Passage of the head across the panel in both directions is also possible so long as there is a sufficient number of ink dispensing nozzles and these are arranged such that ink can be dispensed into grooves formed by the laser beams no matter in which direction the head is moving.

To form several interconnect structures on the same passage of the process head over the substrate, several sets of laser beam delivery optics and fluid nozzles can be used in parallel. Interconnect structures are formed over the whole panel by stepping the process head by distances equal to the cell width or multiples of the cell width in the direction perpendicular to the interconnect direction and traversing the process head across the panel. All the laser beam delivery optics and fluid nozzles are, however, arranged to impinge on the substrate from the coated side only.

As the substrate is transparent, it may be desirable, in some cases, for one or more of the laser beams to strike the substrate from the opposite side of the substrate. In such cases, the laser beam will pass through the glass substrate and interact with the materials that constitute the upper and lower electrodes and the active layer of the solar cell from below.

Rear side interaction methods are known, eg they are used for the scribing of an active layer and the upper electrode layer during the manufacture of solar panels based on amorphous silicon (*α*-Si) as the active material and can be used to scribe all three layers during the manufacture of solar panels based on CdTe as the active material. These known processes all involve multiple stage processes that are dissimilar to the single combined process to which this invention relates. None of these known processes involve the deposition of material in the same pass of the process head.

In a preferred version of the present invention, the use of a process head having first and second parts situated on opposite sides of the panel is proposed for forming the cell interconnecting structures. A first part of the process head is situated on the side of the substrate that is coated with the upper and lower electrode layers and the active layer and carries all the nozzles to deliver all the insulating and conducting inks required to form the cell interconnect structure. The first part of the process head may also have whatever devices are required to cure these inks on the fly and may also have the optics to deliver one or more of the laser beams.

A second part of the process head is situated on the opposite, uncoated, side of the substrate and delivers one or more of the laser beams from the underside of the device.

In operation, the first and second parts of the process head move together across the panel - one above and one below. This may be achieved by the two parts being physically attached or being provided on separate linear stages with a control system such that the positions of the two parts remain locked together. Alternatively, the two parts of the process head may be fixed and the substrate moved between them. In this case, it will be appreciated that the two parts are, in effect, locked together as their positions relative to each other are fixed.

Whilst it is preferred that the first and second part of the process head are arranged to move as one by either physically locking them together or electronically 'locking' the control signals governing the movement of the first and second part, it is also possible to effectively lock them together by ensuring they are accurately aligned initially and then ensuring that control of their movement is sufficiently accurate to maintain this alignment.

It will be appreciated that the single combined process described has significant advantages in ensuring all the cutting and deposition steps are accurately positioned and aligned with respect to each other as well as simplifying the manufacturing process and enabling higher speed processing to be possible. The present invention extends these advantages to situations in which it is desirable (or necessary) to perform at least some of the cutting operations from the underside of the device. This enables different techniques to be used for forming the desired cuts and provides a greater flexibility in the options available. As the two parts of the head are connected and/or arranged to move as one, the alignment and speed benefits of the single combined process are extended to these further techniques. It will be appreciated that, otherwise, the carrying out of different steps from different sides of a substrate would only add to the difficulty of ensuring all stages of the process were accurately aligned.

It is also preferred that some of the laser scribing is performed from the upperside of the device, in particular that used to form the first cut (through all three layers). It is thus advantageous to be able to perform the cutting steps from different sides of the substrate, eg one from above and two from beneath (or vice versa).

As indicated above, one advantage of performing a laser cutting step from beneath is that this enables different cutting techniques to be used. Laser cutting from above, generally involves ablation of material to form a groove, working from the upper surface of the layer into the material of the layer. Laser cutting from beneath can, as the material is irradiated from the opposite direction, be performed by heating the material at the bottom of a groove to be formed so that the material above this is expelled or explodes away from the substrate. This technique is preferred in some situations as it can provide better control of the shape of the groove and/or involves use of lower power lasers. Cutting from beneath the substrate can also be advantageous in that the material expelled from the groove does not travel towards the optics focussing the laser beam onto the substrate so contamination of the optics by the ejected material is avoided. In addition, as the material is expelled from the side of the substrate away from the laser beam (rather than back towards the source of the laser beam), it is easier to collect the expelled material, eg with a suitable extraction nozzle, to prevent it depositing elsewhere on the substrate (the first part of the process head located above the substrate can, if necessary, be positioned away from the expulsion area to provide more space for a debris collection device).
Other preferred and optional features of the invention will be apparent from the subsidiary claims of the specification.

### BRIEF DESCRIPTION OF DRAWINGS

The invention will now be described, merely by way of example, with reference to the accompanying drawings, in which:
Figure 1 shows an enlarged, schematic, plan view of part of the known apparatus described in WO 2011/048352; it shows an arrangement of the three laser beams and two ink jet nozzles that are attached to a process head in order to make a single cell interconnect structure;
Figure 2 shows an enlarged, schematic, plan view of another embodiment of the known apparatus described in WO 2011/048352; it shows an arrangement of the three laser beams and two sets of associated ink jet nozzles that are attached to a process head in order to make single cell interconnect structures by moving the process head in either direction;
Figure 3 illustrates the sequence of laser and ink jet processes described in WO 2011/048352 for dividing a thin film device into separate cells;
Figure 4 shows known apparatus for moving a substrate in two directions with respect to a process head as described in WO 2011/048352;
Figure 5 is a schematic side view of the apparatus shown in Figure 4 (with some parts omitted);
Figure 6 shows an enlarged, schematic, plan view of part of a known process head as described in WO 2011/048352; it demonstrates how an array of laser beams and two arrays of ink jet nozzles can be mounted on a process head and used to form multiple adjacent cell interconnecting structures in a single pass in either direction over a panel;
Figure 7 illustrates the sequence of laser and ink jet processes according to a first embodiment of the present invention for dividing a thin film device into separate cells;
Figure 8 is a schematic side view of apparatus that may be used in the process illustrated in Figure 7;
Figure 9 illustrates the sequence of laser and ink jet processes according to a second embodiment of the present invention for dividing a thin film device into separate cells;
Figure 10 is a schematic side view of apparatus that may be used in the process illustrated in Figure 9; and
Figure 11 is a schematic perspective view of another form of apparatus that may be used in the processes illustrated in Figures 7 and 9.

### DETAILED DESCRIPTION OF THE DRAWINGS

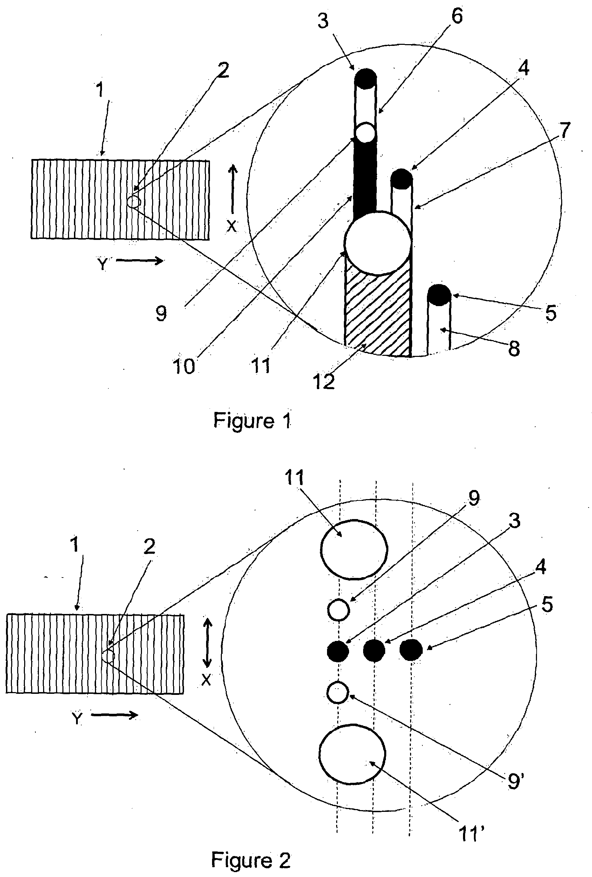

FIGURE 1 shows prior art based on WO 2011/048352. It shows a first arrangement of three laser beams and two ink jet nozzles that are attached to a process head in order to make a single cell interconnect structure in a single pass of the head. A solar panel 1 has multiple cells along its length in the direction Y. Interconnections are thus made by relative motion of the process head with respect to the panel in the direction X. An area 2 of the panel that includes a region where adjacent cells are to be formed and connected is shown enlarged on the right side of the figure. This shows part of the moving process head with its associated laser beams and ink jet nozzles that correspond to a single cell interconnect structure. The solar panel comprises a lower electrode layer, an active layer and an upper electrode layer and first, second and third laser beams 3, 4 and 5 make, respectively, a first scribe 6 through all three layers, a second scribe 7 through the top two layers and a third scribe 8 through the top layer. The third laser beam can penetrate the active layer but must not penetrate the lower electrode layer. The figure indicates the process. head and attached laser beams moving in the X direction with respect to the substrate such that, on the substrate surface, the first laser beam 3 is in advance of the second laser beam 4 which is likewise in advance of the third laser beam 5. An ink jet nozzle 9 is attached to the process head and is situated on a line that is parallel to the X direction and passes through the position of the first laser beam 3. This nozzle 9 injects a continuous stream or stream of droplets of insulating fluid 10 to fill the first laser scribe line 6. A second ink jet nozzle 11, that is either similar to the first nozzle but operating at a similar or higher droplet expulsion rate, or is either similar or larger in terms of droplet size emitted or consists of multiple smaller nozzles, is also attached to the process head and is situated in the X direction such that when the process head is moving over the substrate, the second ink jet nozzle 11 follows the first ink jet head 9 and the second laser beam 4. This second ink jet nozzle 11 injects a continuous stream or stream of droplets of conducting fluid 12. The nozzle is situated in the Y direction above the first and second laser scribes 6 and 7 such that the fluid 12 is deposited on the substrate surface and forms an electrically conducting bridge over the previously applied insulating fluid 10, the bridge extending from the upper electrode surface on the left side of the first scribe 6 to the lower electrode surface at the base of the second scribe 7. As the process head moves across the substrate in the X direction, the order of the five processes carried out to form and complete the interconnect structure is as follows:-
1) Laser scribe line 6 through all three layers by first laser beam 3
2) Fill first laser scribe line 6 with insulating ink 10 delivered by first ink jet nozzle 9
3) Laser scribe line 7 through top 2 layers by second laser beam 4
4) Form conducting bridge across first laser scribe line 6 to second laser scribe line 7 with conducting ink 12 delivered by second ink jet nozzle 11
5) Laser scribe line 7 through top layer by third laser beam 4.

It is generally necessary to cure the insulating ink before applying the conducting ink so curing devices (not shown) that locally apply heat or ultra violet (UV) light are used. These are attached to the process head at an appropriate position such as between nozzles 9 and 11 Instead of moving the process head over a stationary substrate surface in the direction X (as shown), the same sequence of laser and ink jet processes can be achieved by holding the process head stationary and moving the panel in the opposite X direction.

There are many alternative arrangements for the positions of the various laser beams and nozzles on the process head as indicated in WO 2011/048352. In all cases, in order to make a satisfactory interconnect the essentials are that:
1) The first laser scribe process must always precede the first printing process
2) The first printing process must always precede the second printing process
3) The second laser scribe process must always precede the second printing process.

With the arrangement of laser beams and nozzles shown in figure 1, and in any arrangement where the nozzles are situated on one side only of the first and second laser beams, then the process head can form an interconnect by moving in one direction only across the substrate. Such an arrangement can limit the rate at which interconnects are formed so a preferred arrangement has nozzles on both sides of the first and second laser beams thus allowing interconnect formation in both directions.

FIGURE 2 shows further prior art based on WO 2011/048352. This figure shows an arrangement of three laser beams and two first ink jet heads and two second ink jet heads positioned to allow operation of the head in either direction. A solar panel 1 has multiple cells along its length in direction Y. This means that interconnections are made by moving the panel with respect to the process head in either of the X directions. An area 2 of the panel that includes a region where adjacent cells are connected is shown enlarged on the right side of the figure and shows part of the moving process head with its associated laser beams and ink jet nozzles that correspond to a single cell interconnect structure. First, second and third laser beams 3, 4 and 5, respectively, make a first scribe through all three layers, a second scribe through the top two layers and a third scribe through the top layer. Two first ink jet nozzles 9 and 9' are attached to the process head and are situated on each side of the first laser beam on a line that is parallel to the X direction and passes through the position of the first laser beam 3. These first nozzles inject a stream of insulating fluid to fill the first laser scribe. Two second, larger, ink jet nozzles, or multiple smaller nozzles, 11 and 11' are also attached to the process head and are situated on each side of the first laser beam on a line that is parallel to the X direction and passes through a position close to the first laser beam 3. These second ink jet nozzles inject a stream of conducting fluid. The nozzles 11 and 11' are situated in the Y direction above first and second laser scribes 6 and 7 such that the conducting fluid deposited on the substrate surface forms an electrically conducting bridge over the previously applied insulating fluid, the bridge extending from the upper electrode surface on the left side of the first scribe to the lower electrode surface at the base of the second scribe. As the process head moves across the substrate in either of the X directions, one or other of each first ink jet nozzle and one or other of the corresponding second ink jet nozzle are activated such that the order of the five processes carried out to form and complete the interconnect structure is as follows:-
1) Carry out first, second and third laser scribes with first, second and third laser beams.
2) Fill first laser scribe line with insulating ink delivered by either first ink jet nozzle 9 or 9' depending on the head travel direction
3) Form conducting bridge across first laser scribe line to second laser scribe line with conducting ink delivered by either second ink jet nozzle 11 or 11' depending on the head travel direction.

It is generally necessary to cure the insulating ink before applying the conducting ink so curing devices (not shown) that locally apply heat or UV light are used. These are attached to the process head at an appropriate position such as between nozzles 9 and 11 and between nozzles 9' and 11'.

Instead of moving the process head over the stationary substrate surface in the direction X (as shown), the same sequence of laser and ink jet processes can be achieved by holding the process head stationary and moving the panel in the opposite X direction.

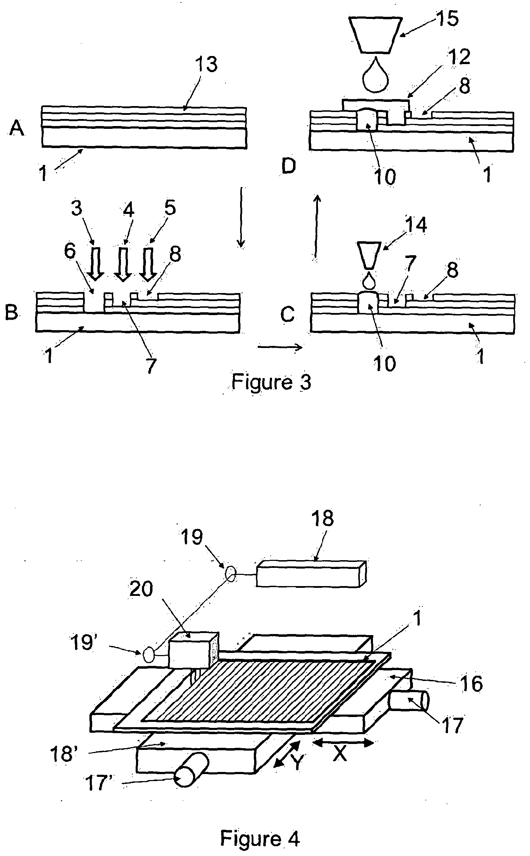

FIGURE 3 shows the time sequence of the laser and ink jet processes delivered to the substrate surface by the apparatus shown in figure 2. Fig 3A shows a substrate 1 on which a stack of layers 13 consisting of a lower electrode layer, an active layer and an upper electrode layer has been deposited. These layers are applied sequentially without any intermediate laser processes. Fig 3B shows the three laser processes that are then carried out. A first laser beam 3 is incident on the coatings and scribes a groove 6 that penetrates all 3 layers as far as the substrate. A second laser beam 4 is also incident on the coatings and scribes a groove 4 that penetrates the top two layers but not the lower electrode layer. A third laser beam 5 is also incident on the coatings and scribes a groove 8 that penetrates the top electrode layer and may also penetrate into the active layer but should not disrupt the lower electrode layer. According to the arrangement of laser beams shown in figure 2 these 3 laser scribes are made at the same time but this is not essential and they can be carried out sequentially. In addition, the order in which they are made is not critical. After all three laser processes have been completed materials are applied by ink jet printing.

Figure 3C shows how an insulating fluid 10 is applied into the first laser scribe by means of an ink jet nozzle 14. The fluid 10 is immediately UV cured or later thermally cured to form a solid. Fig 3D shows the next step where a fluid 12 that is conducting or contains conducting particles is applied by means of an ink jet nozzle 15 over the insulating material 10 in the first scribe and also into the second laser scribe. The fluid 12 is subsequently thermally cured to form a solid. The fluid 12 does not extend into the third scribe 8. The conducting material 12 forms a bridge over the insulating material 10 to electrically connect the top electrode layer on the left side to the bottom electrode layer on the right side to connect adjacent cells in series.

FIGURE 4 shows apparatus appropriate for carrying out the cell interconnection process shown in figures 1 or 2. Solar panel 1 is mounted on a flat chuck plate which is mounted on translation stages 16 and 16' driven by suitable motors such as stepper motors or servo motors 17, 17' so that the panel is able to move in two orthogonal directions X and Y parallel to the edges of the panel. The beam from laser unit 18 is directed by mirrors 19, 19' to a process head 20 that is mounted over the panel. Details of the optics in the process head to split the beam into first, second and third laser beams as well as the associated first and second ink jet heads on the process head are not shown in the figure. In operation, the process head is stationary and the panel is moved in a series of linear moves in the Y direction each pass across the substrate being followed by a step in the X direction. The process head may process a single cell interconnect on each pass in either a single direction by using the head component arrangement shown in figure 1 or in both directions using the head component arrangement shown in figure 2. The figure shows a stationary process head with the substrate moving in two axes but in practice other arrangements are possible. A preferred arrangement has the substrate moving in one axis and the process head moving in the other. An arrangement where the process head moves in two orthogonal axes over a stationary substrate is also possible. The first, second and third laser beams can originate from a single laser source or from multiple laser sources of similar or different type.

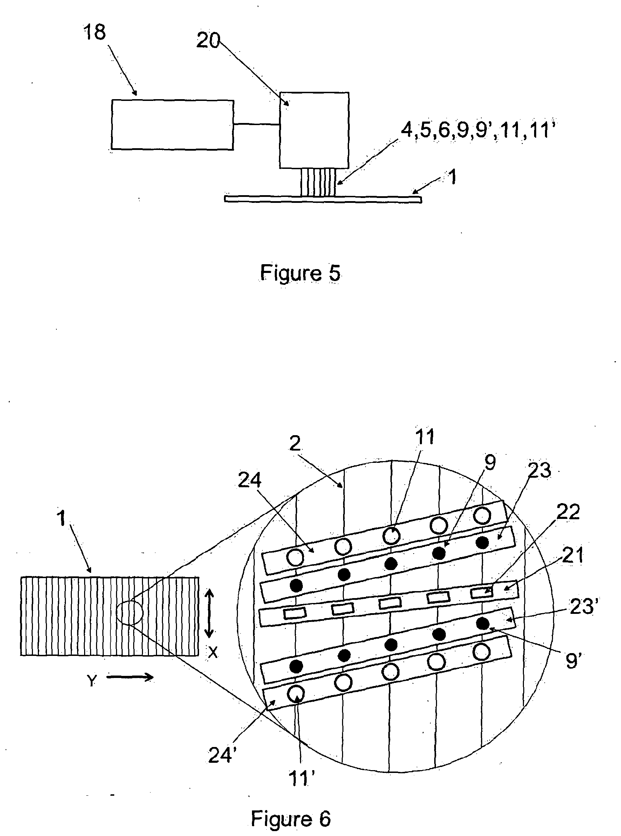

FIGURE 5 shows prior art based on WO 2011/048352. This figure shows a simplified diagram of the apparatus shown in Figure 4 emphasizing that a single process head 20 is used to deliver all three laser beams 3, 4 and 5 originating from single or multiple lasers 18 as well as all insulating and conducting inks originating from first ink jet nozzles 9 and 9' and second ink jet nozzles 11 and 11' to just one side of the substrate 1; that side being the side having the stack of coatings applied.

FIGURE 6 shows how an individual interconnect process unit as shown in Figure 2 can be expanded to provide a device that can simultaneously process multiple interconnect structures in parallel. The figure shows a solar panel 1 with multiple cells along its length Y. An area 2 of the panel that includes the connections between several cells is shown enlarged on the right of the figure. This shows part of the moving process head with its associated laser beams and ink jet nozzles that correspond (in this example) to five cell interconnect structures. A device 21 holds and positions the five parallel sets of first, second and third laser beams 22 along a line. Individual beams are not shown. The device can be rotated about an axis perpendicular to the plane of the diagram to set the spacing between the sets of beams in the Y direction to match the cell pitch exactly. The row of five sets of first, second and third beams makes five parallel first cuts through the 3 layers, five parallel second cuts through the second and third layers and five parallel third cuts through the top layer. Devices 23 and 23' hold and position five parallel first ink jet nozzles 9 or 9' along a line in order to apply five parallel lines of insulating fluid into the five first laser cuts. The devices can be rotated about axes perpendicular to the plane of the diagram to set the spacing between the nozzles in the Y direction to match the cell pitch exactly. Either set of first ink jet nozzles is activated depending on the direction of travel of the process head in the X direction with respect to the substrate surface such that the insulating ink application follows the first laser cut. Devices 24 and 24' hold and position five parallel second ink jet nozzles 11 or 11' along a line in order to apply five parallel lines of conducting fluid over the insulating fluid in the five first cuts and into the five second laser cuts. The devices can be rotated about axes perpendicular the plane of the diagram to set the spacing between the nozzles in the Y direction to match the cell pitch exactly. Either set of second ink jet nozzles is activated depending on the direction of travel of the process head in the X direction with respect to the substrate surface such that the conducting ink application follows the insulating ink application which follows the first and second laser cuts. The panel 1 and process head are moved relative to each other in either X direction so that areas of the substrate see in succession:-
1) the row of first, second and third laser beams,
2) a row of first ink jet nozzles and
3) a row of second ink jet nozzles.

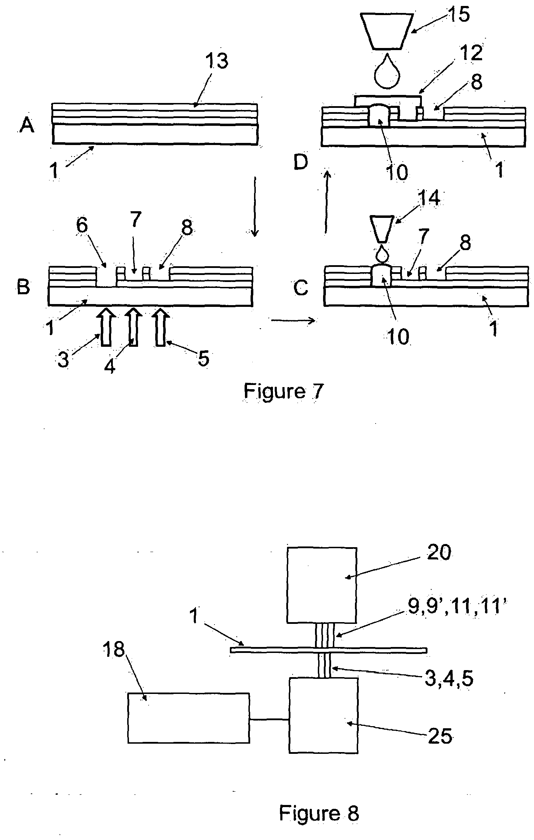

FIGURE 7 illustrates an embodiment of a process according to the present invention and shows the time sequence of laser and ink jet processes delivered to a substrate. Fig 7A shows a transparent substrate 1 on which a stack of layers 13 consisting of a lower electrode layer, an active layer and an upper electrode layer has been deposited. These layers are applied sequentially without any intermediate laser processes. Fig 7B shows the three laser processes that are then carried out which, in this example, are all incident on the substrate from the lower, non-coated, side of the substrate. A first laser beam 3 interacts with the coatings from below and removes all three of the layers to form a groove 6 that extends through all three layers as far as the substrate surface. A second laser beam 4 also interacts with the coatings from below and removes the top two layers to form a groove 7 through the top two layers but not the lower electrode layer. A third laser beam 5 also interacts with the coatings from below and removes at least the top layer to form a groove 8 through the top electrode layer. Laser beam 5 can also partially or fully remove the active layer (as shown in the figure) without influencing the effectiveness of the cell interconnection structure. The three laser scribes can be made at the same time or they can be carried out sequentially. The order in which they are made is not critical. After all three laser processes have been completed, materials are applied by ink jet printing. Figure 7C shows how an insulating fluid 10 is applied into the first laser scribe by means of an ink jet nozzle 14. The fluid 10 is immediately UV cured or later thermally cured to form a solid. Fig 7D shows the next step where a fluid 12 that is conducting or contains conducting particles is applied by means of an ink jet nozzle 15 over the insulating material 10 in the first scribe and also into the second laser scribe. The fluid 12 is subsequently thermally or otherwise cured to form a solid. The fluid 12 does not extend into the third scribe 8. The conducting material 12 forms a bridge over the insulating material 10 to electrically connect the top electrode layer on the left side to the bottom electrode layer on the right side to connect adjacent cells in series.

FIGURE 8 shows an arrangement of the first and second parts of a process head that can be used to carry out the process shown in Figure 7. The first part 20 of the process head delivers all insulating and conducting inks originating from first ink jet nozzles 9 and 9' and second ink jet nozzles 11 and 11' to the side of the substrate 1 that has the stack of coatings applied. The second part 25 of the process head delivers all three laser beams 3, 4 and 5 to the substrate such that the beams can penetrate the glass substrate and interact with the various layers on the upper side of the substrate. The relative positions in the plane parallel to the substrate surface of the first and second parts of the process head are adjusted and maintained so that the inks deposited by the nozzles on the first part of the process head correspond exactly to the grooves in the layers created by the laser beams delivered by the second part of the process head.

First, second and third laser beams can originate from a single laser source or from multiple laser sources. In the latter case, the lasers can be of similar type or of different type.

Relative motion between the process head and the substrate can be achieved by several methods; both parts of the process head can be held stationary and the substrate moved in two axes, the substrate moved in one axis and both parts of the process head moved together in the other axis and both parts of the process head moved together in two orthogonal axes with a stationary substrate.

The arrangement shown in Figure 8 can be readily extended to allow multiple cell interconnects to be made at the same time in a single pass of the process head over the substrate using devices of the type shown in Figure 6. In this case, rather than only sufficient first and second nozzles for making a single interconnect being mounted on the first part of the process head, appropriate devices are used to mount several sets of first and second nozzles operating in parallel; the sets being separated by the cell pitch or multiples of the cell pitch. In addition, rather than only three laser beams being delivered by the second part of the process head, appropriate devices are used to deliver several sets of laser beams operating in parallel the sets being separated by the cell pitch or multiples of the cell pitch.

In addition to the ink-jet nozzles and laser sources, the first part of the process head may also be provided with a debris collection device (not shown), eg a suction nozzle, to remove debris ejected from the upper side of the substrate when laser cutting is carried out using a laser source on the second part of the process head.

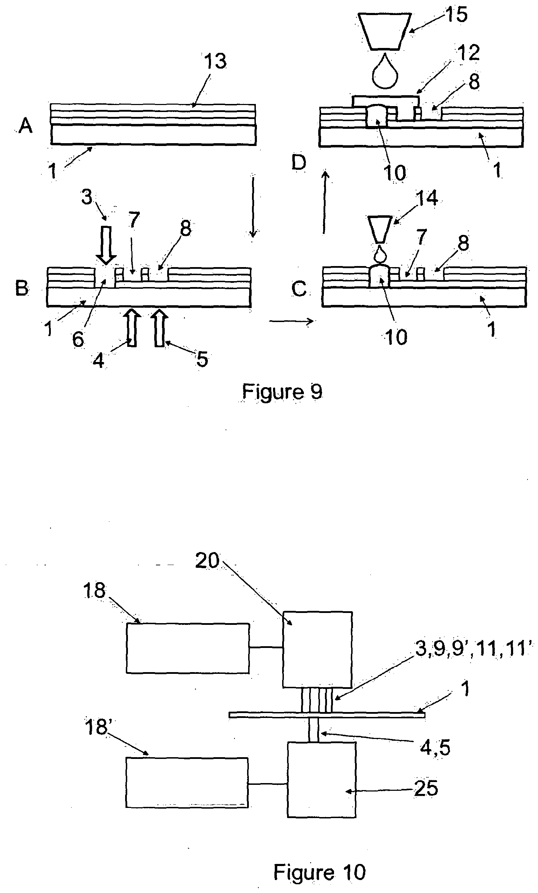

FIGURE 9 shows the time sequence of the laser and ink jet processes delivered to the substrate according to another preferred aspect of the invention. The process head comprises two opposing parts but in this case one of the laser beams is delivered to the coated side by the first part of the process head while the remaining two of the three laser beams are delivered to the substrate from the non-coated side by the second part of the process head. Fig 9A shows a substrate 1 on which a stack of layers 13 consisting of a lower electrode layer, an active layer and an upper electrode layer has been deposited. These layers are applied sequentially without any intermediate laser processes. Fig 9B shows the three laser processes that are then carried out which in this case are incident from both sides of the substrate. A first laser beam 3 is incident on the coatings from above and scribes a groove 6 that penetrates all 3 layers as far as the substrate. A second laser beam 4 interacts with the coatings from below and removes the top two layers to forms a groove 7 that separates the top two layers but not the lower electrode layer. A third laser beam 5 also interacts with the coatings from below and removes at least the top layer to form a groove 8 that separates the top electrode layer. Laser beam 5 can also remove the active layer (as shown in the figure) without influencing the effectiveness of the cell interconnection structure. The three laser scribes can all be made at the same time or they can be carried out sequentially. The order in which they are made is not critical. After all three laser processes have been completed, materials are applied by ink jet printing. Figure 9C shows how an insulating fluid 10 is applied into the first laser scribe by means of an ink jet nozzle 14. The fluid 10 is immediately UV cured or later thermally cured to form a solid. Fig 9D shows the next step where a fluid 12 that is conducting or contains conducting particles, is applied by means of an ink jet nozzle 15 over the insulating material 10 in the first scribe and also into the second laser scribe. The fluid 12 is subsequently thermally cured to form a solid. The fluid 12 does not extend into the third scribe 8. The conducting material 12 forms a bridge over the insulating material 10 to electrically connect the top electrode layer on the left side to the bottom electrode layer on the right side to connect adjacent cells in series.

FIGURE 10 shows an arrangement of the first and second parts of the process head that can be used to carry out the process shown in Figure 9. A first part 20 of the process head delivers all insulating and conducting inks originating from first ink jet nozzles 9 and 9' and second ink jet nozzles 11 and 11' to the side of the substrate 1 that has the stack of coatings applied. First laser beam 3 that originates from laser 18 is also delivered to the upper, coated, side of the substrate by the first part 20 of the process head. A second part 25 of the process head delivers second and third laser beams 4 and 5 to the substrate such that the beams can penetrate the glass substrate and interact with the various layers on the upper side of the substrate. Second and third laser beams can originate from the same single laser source 18' or from multiple laser sources. In the latter case, the lasers can be of the same or different type.

Many other distributions of the beams than those shown in figures 7, 8, 9 and 10 are possible;
a) first and second beams from the coated side, third beam from the uncoated side
b) first and third beams from the coated side, second beam from the uncoated side
c) second and third beams from the coated side, first beam from the uncoated side
d) first and second beams from the uncoated side, third beam from the coated side
e) first and third beams from the uncoated side, second beam from the coated side.

The arrangement shown in Figure 10 and all those listed above can also be readily extended to allow multiple cell interconnects to be made at the same time in a single pass of the head over the substrate using devices of the type shown in Figure 6. In this case, rather than only sufficient first and second ink jet nozzles for making a single interconnect being mounted on the first part of the process head, appropriate devices are used to mount several sets of first and second ink jet nozzles operating in parallel the sets being separated by the cell pitch or multiples of the cell pitch. In addition, rather than only one set of three laser beams being delivered by a combination of the first and second parts of the process head, appropriate devices are used to deliver several sets of laser three beams operating in parallel the sets being separated by the cell pitch or multiples of the cell pitch.

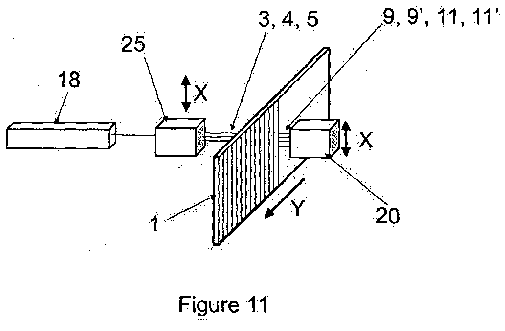

Figure 11 shows an alternative apparatus for carrying out the interconnect formation process described above. Figures 4, 5, 8 and 10 all show a preferred arrangement where the substrate is arranged horizontally with the coated side upwards with first part of the process head above and second part of the process head below the substrate. Other arrangements to this are possible and a preferred one is shown in Figure 11. In this case, the substrate 1 is arranged to be vertical with the first and second parts of the process head on each side thereof. In the arrangement shown, a first part 20 of the process head contains first ink jet nozzles 9 and 9' and second ink jet nozzles 11 and 11' for delivering the insulating inks and conducting inks to the coated side of the substrate while a second part of the process head 25 delivers first, second and third laser beams 3, 4, and 5 from laser source (or sources) 18 to the side of the substrate that is opposite to the coated side. The cell interconnect structures are vertical and the two parts of the process head forming the interconnection structures move together on opposite sides of the substrate in the vertical X direction while the substrate moves through the apparatus in the horizontal Y direction as shown.

Other arrangements whereby some of the first, second and third laser beams are delivered by the first part of the process head are also possible

The process and apparatus described above has several key features:
1) First and second parts of the process head being located on opposite sides of the substrate
2) The first part of the process head on the coated side of substrate delivers all insulating and conducting inks
3) The second part of the process head on the uncoated side of substrate delivers at least one laser beam.
4) Laser beams not delivered by the second part of the process head are delivered by the first part of the process head
5) The positions of the first and second parts of the process head are locked together so they move as one (relative to the substrate)
6) The first and second parts of the process head together form a cell interconnect in a single pass over substrate
7) The process head can be arranged to create interconnects in single or dual direction
8) The process head can be arranged to form one or more interconnects in single pass
9) The substrate can be horizontal or vertical
10) One or more of the laser layer scribing processes carried out by the first part of the process head can be replaced by a mechanical scribe process.

## Claims

1. A method for dividing a thin film device having a first layer which is a lower electrode layer, a second layer which is an active layer and a third layer which is an upper electrode layer, all the layers being continuous over the device, into separate cells which are electrically interconnected in series, the dividing of the cells and the electrical connection between adjacent cells all being carried out in a single pass of process head across the device, the process head comprising a first part (20) positioned above the device and a second part (25) positioned beneath the device, the first and second parts of the process head together performing the following steps in the single pass:
a) making a first cut (6) through the first, second and third layers;
b) making a second cut (7) through the second and third layers, the second cut being adjacent to the first cut;
c) making a third cut (8) through the third layer the third cut being adjacent to the second cut and on the opposite side of the second cut to the first cut;
d) using a first ink jet print head (9, 9') on the first part (20) of the process head to deposit a non-conducting material (10) into the first cut; and
e) using a second ink jet print head (11, 11') on the first part (20) of the process head to apply conducting material (12) to bridge the non-conducting material in the first cut and either fully or partially fill the second cut such that an electrical connection is made between the first layer and the third layer,
wherein step (a) precedes step (d), step (d) precedes step (e) and step (b) precedes step (e), otherwise the steps may be carried out in any order in the single pass of the process head across the device and wherein at least one of the first, second or third cuts (6, 7, 8) is formed using a laser beam (3, 4, 5) directed from the second part (25) of the process head towards said first, second and third layers from the underside of the device.

2. A method as claimed in claim 1 in which the order in which the steps are carried out in the single pass is determined by the relative positions on the process head of the first and second ink jet print heads and components on said process head for forming said first, second and third cuts.

3. A method as claimed in claim 1 or 2 in which two or more of the first, second and third cuts are formed using laser beams.

4. A method as claimed in claim 1, 2 or 3 in which the first cut is formed from above the device by cutting means carried by the first part of the process head and the second and/or third cuts are formed using laser beams directed from the second part of the process head towards the underside of the device.

5. A method as claimed in any preceding claim in which the process head is able to carry out all said steps in a single pass in either or both directions across the thin film device.

6. A method as claimed in any preceding step in which one or more curing steps are carried out during said single pass after deposition of the non-conducting material and/or said conducting material.

7. A method as claimed in any preceding claim in which the first and second parts of the process head are arranged to move as one relative to the device so their positions relative to each other are fixed.

8. A method as claimed in any preceding claim in which the thin film device is one of the following: a solar panel, a lighting panel and a battery.

9. Apparatus for dividing a thin film device having a first layer which is a lower electrode layer, a second layer which is an active layer and a third layer which is an upper electrode layer, all the layers being continuous over the device, into separate cells which are electrically interconnected in series, the apparatus comprising a process head having a first part (20) arranged to be positioned above the device and a second part (25) arranged to be positioned beneath the device, the first and second parts of the process head together being provided with:
a) one or more cutter units for making a first cut though the first, second and third layers, a second cut though the second and third layers adjacent to the first cut and a third cut through the third layer adjacent to the second cut and on the opposite side of the second cut to the first cut;
b) a first ink jet print head (9,9') for depositing a non-conducting material into the first cut; and
c) a second ink jet print head (11,11') for applying conducting material to bridge the non-conducting material in the first cut and either fully or partially fill the second cut so that an electrical connection is made between the first layer and the third layer,
the apparatus also comprising:
d) drive means for moving the process head relative to the device; and
e) control means for controlling movement of the process head relative to the device and actuating said one or more cutter units and said first and second ink jet print heads (9,9',11,11') so that division of the device into separate cells and the formation of an electrical connection between adjacent cells can all be carried out in a single pass of the process head across the device, wherein the first and second ink jet print heads (9,9',11,11') are provided on the first part (20) of the process head and arranged to apply material to an upper side of the device and the or one of the cutter units is provided on the second part (25) of the process head and arranged to form at least one of the first, second or third cuts by means of a laser beam (3,4,5) directed therefrom towards said first, second and third layers from the underside of the device.

10. Apparatus as claimed in claim 9 in which said one or more cutter units are provided on the second part of the process head and comprise one or more pulsed lasers for forming the first, second and third cuts.

11. Apparatus as claimed in claim 9 in which said one or more cutter units comprise pulsed lasers of two or more types for forming the first, second and/or third cuts.

12. Apparatus as claimed in claims 9, 10 or 11 in which the relative positions on the process head of the first and second ink jet print heads and the cutter units on said process head for forming said first, second and third cuts determine the order in which the steps are carried out in the single pass of the process head.

13. Apparatus as claimed in any of claims 9 to 12 in which one or more curing devices are provided on the first part of the process head for curing the non-conducting material and/or the conducting material applied by the first and/or second ink jet heads during the single pass of the process head.

14. Apparatus as claimed in any of claims 9 to 13 in which the control system is arranged so that the device and process head move relative to each other in a first direction parallel to the lengths of the first and second cuts in a continuous path across the device and at the end of the path to step in a direction perpendicular to the first direction by a predetermined distance equal to the width of the cells to be formed in the device or an integral multiple thereof.

15. Apparatus as claimed in any of claims 9 to 14 in which a debris collection device is provided on the first part of the process head for collecting material expelled from the upper side of the device when a cutter unit on the second part of the process head is used to form one of the first, second or third cuts.

## Patentansprüche

1. Verfahren zum Teilen einer Dünnfilmvorrichtung mit einer ersten Schicht, die eine untere Elektrodenschicht ist, einer zweiten Schicht, die eine aktive Schicht ist, und einer dritten Schicht, die eine obere Elektrodenschicht ist, wobei alle Schichten über der Vorrichtung durchgehend sind, in einzelne Zellen, die in Reihe elektrisch miteinander verbunden sind, wobei das Teilen der Zellen und der elektrischen Verbindung zwischen benachbarten Zellen in einem einzigen Durchgang des Prozesskopfs über die Vorrichtung ausgeführt wird, wobei der Prozesskopf einen ersten Teil (20), der über der Vorrichtung positioniert ist, und einen zweiten Teil (25) umfasst, der unter der Vorrichtung positioniert ist, wobei der erste und zweite Teil des Prozesskopfs zusammen die folgenden Schritte in dem einzigen Durchgang durchführen:
a) Vornehmen eines ersten Schnitts (6) durch die erste, zweite und dritte Schicht;
b) Vornehmen eines zweiten Schnitts (7) durch die zweite und dritte Schicht, wobei der zweite Schnitt benachbart zum ersten Schnitt ist;
c) Vornehmen eines dritten Schnitts (8) durch die dritte Schicht, wobei der dritte Schnitt benachbart zu dem zweiten Schnitt und auf der gegenüberliegenden Seite des zweiten Schnitts zu dem ersten Schnitt ist;
d) Verwenden eines ersten Tintenstrahldruckkopfs (9,9') an dem ersten Teil (20) des Prozesskopfs, um ein nichtleitendes Material (10) in den ersten Schnitt abzuscheiden; und
e) Verwenden eines zweiten Tintenstrahldruckkopfs (11, 11') an dem ersten Teil (20) des Prozesskopfs, um ein leitendes Material (12) aufzutragen, um das nichtleitende Material in dem ersten Schnitt zu überbrücken und um den zweiten Schnitt entweder vollständig oder teilweise zu füllen, sodass eine elektrische Verbindung zwischen der ersten Schicht und der dritten Schicht hergestellt wird,
wobei Schritt (a) Schritt (d) vorangeht, Schritt (d) Schritt (e) vorangeht und Schritt (b) Schritt (e) vorangeht, ansonsten können die Schritte in beliebiger Reihenfolge in dem ersten Durchgang des Prozesskopfs über die Vorrichtung ausgeführt werden, und wobei mindestens einer des ersten, zweiten oder dritten Schnitts (6, 7, 8) unter Verwendung eines Laserstrahls (3, 4, 5) gebildet ist, der von dem zweiten Teil (25) des Prozesskopfs zu der ersten, zweiten und dritten Schicht von der Unterseite der Vorrichtung ausgerichtet ist.

2. Verfahren nach Anspruch 1, in dem die Reihenfolge, in der die Schritte in dem einzigen Durchgang ausgeführt werden, durch die relativen Positionen an dem Prozesskopf des ersten und zweiten Tintenstrahldruckkopfs und Komponenten an dem Prozesskopf zum Bilden des ersten, zweiten und dritten Schnitts bestimmt ist.

3. Verfahren nach Anspruch 1 oder 2, in dem zwei oder mehr des ersten, zweiten und dritten Schnitts unter Verwendung von Laserstrahlen gebildet werden.

4. Verfahren nach Anspruch 1, 2 oder 3, in dem der erste Schnitt von oberhalb der Vorrichtung durch Schneidemittel gebildet ist, die durch den ersten Teil des Prozesskopfs getragen werden, und der zweite und/oder dritte Schnitt unter Verwendung von Laserstrahlen gebildet ist, die von dem zweiten Teil des Prozesskopfs zu der Unterseite der Vorrichtung ausgerichtet sind.

5. Verfahren nach einem vorhergehenden Anspruch, in dem der Prozesskopf in der Lage ist, alle Schritte in einem einzigen Durchgang in eine der beiden oder beide Richtungen über die Dünnfilmvorrichtung auszuführen.

6. Verfahren nach einem vorhergehenden Schritt, in dem ein oder mehrere Aushärtungsschritte während dem einzigen Durchgang nach der Abscheidung des nichtleitenden Materials und/oder des leitenden Materials ausgeführt werden.

7. Verfahren nach einem vorhergehenden Anspruch, in dem der erste und zweite Teil des Prozesskopfs angeordnet sind, um sich wie eine Einheit relativ zu der Vorrichtung zu bewegen, sodass ihre Positionen relativ zueinander fest sind.

8. Verfahren nach einem vorhergehenden Anspruch, in dem die Dünnfilmvorrichtung eines des Folgenden ist: ein Solarpanel, ein Lichtpaneel und eine Batterie.

9. Gerät zum Teilen einer Dünnfilmvorrichtung mit einer ersten Schicht, die eine untere Elektrodenschicht ist, einer zweiten Schicht, die eine aktive Schicht ist, und einer dritten Schicht, die eine obere Elektrodenschicht ist, wobei alle Schichten über der Vorrichtung durchgehend sind, in einzelne Zellen, die in Reihe elektrisch miteinander verbunden sind, wobei das Gerät einen Prozesskopf mit einem ersten Teil (20), der angeordnet ist, um über der Vorrichtung positioniert zu sein, und einem zweiten Teil (25) umfasst, der angeordnet ist, um unter der Vorrichtung positioniert zu sein, wobei der erste und zweite Teil des Prozesskopfs zusammen mit Folgendem bereitgestellt sind:
a) einer oder mehreren Schneideeinheiten, um einen ersten Schnitt durch die erste, zweite und dritte Schicht, einen zweiten Schnitt durch die zweite und dritte Schicht, die benachbart zu dem ersten Schnitt sind, und einen dritten Schnitt durch die dritte Schicht vorzunehmen, die benachbart zu dem zweiten Schnitt und an der gegenüberliegenden Seite des zweiten Schnitts zu dem ersten Schnitt ist;
b) einem ersten Tintenstrahldruckkopf (9, 9'), um ein nichtleitendes Material in den ersten Schnitt abzuscheiden; und
c) einem zweiten Tintenstrahldruckkopf (11, 11'), um ein leitendes Material aufzutragen, um das nichtleitende Material in dem ersten Schnitt zu überbrücken und um den zweiten Schnitt entweder vollständig oder teilweise zu füllen, sodass eine elektrische Verbindung zwischen der ersten Schicht und der dritten Schicht hergestellt wird,
wobei das Gerät zudem Folgendes umfasst:
d) Antriebsmittel, um den Prozesskopf relativ zu der Vorrichtung zu bewegen; und
e) Steuermittel zum Steuern von Bewegung des Prozesskopfs relativ zu der Vorrichtung und zum Betätigen der einen oder mehreren Schneidemittel und des ersten und zweiten Tintenstrahldruckkopfs (9, 9', 11, 11'), sodass ein Teilen der Vorrichtung in einzelne Zellen und das Bilden einer elektrischen Verbindung zwischen benachbarten Zellen in einem einzigen Durchgang des Prozesskopfs über die Vorrichtung ausgeführt werden kann, wobei der erste und zweite Tintenstrahldruckkopf (9, 9', 11, 11') an dem ersten Teil (20) des Prozesskopfs bereitgestellt und angeordnet sind, um Material auf eine Oberseite der Vorrichtung aufzutragen, und die oder eine der Schneideeinheiten an dem zweiten Teil (25) des Prozesskopfs bereitgestellt und angeordnet ist, um mindestens einen des ersten, zweiten oder dritten Schnitts durch einen Laserstrahl (3, 4, 5) zu bilden, der von dort zu der ersten, zweiten und dritten Schicht von der Unterseite der Vorrichtung ausgerichtet ist.

10. Gerät nach Anspruch 9, in dem die eine oder mehreren Schneideeinheiten an dem zweiten Teil des Prozesskopfs bereitgestellt sind und einen der mehrere Pulslaser zum Bilden des ersten, zweiten und dritten Schnitts umfassen.

11. Gerät nach Anspruch 9, in dem die eine oder mehreren Schneideeinheiten Pulslaser von zwei oder mehreren Arten zum Bilden des ersten, zweiten und/oder dritten Schnitts umfassen.

12. Gerät nach Ansprüchen 9, 10 oder 11, in dem die relativen Positionen an dem Prozesskopf des ersten und zweiten Tintenstrahldruckkopfs und die Schneideeinheiten an dem Prozesskopf zum Bilden des ersten, zweiten und dritten Schnitts die Reihenfolge bestimmen, in der die Schritte in dem einzigen Durchgang des Prozesskopfs ausgeführt werden.

13. Gerät nach einem der Ansprüche 9 bis 12, in dem eine oder mehrere Aushärtungsvorrichtungen an dem ersten Teil des Prozesskopfs bereitgestellt sind, um das nichtleitende Material und/oder das leitende Material auszuhärten, das durch den ersten und/oder zweiten Tintenstrahldruckkopf während des einzigen Durchgangs des Prozesskopfs aufgetragen wird.

14. Gerät nach einem der Ansprüche 9 bis 13, in dem das Steuersystem angeordnet ist, sodass sich die Vorrichtung und der Prozesskopf relativ zueinander in eine erste Richtung parallel zu den Längen des ersten und zweiten Schnitts in einem kontinuierlichen Pfad über die Vorrichtung bewegen und an dem Ende des Pfads in eine Richtung senkrecht zu der ersten Richtung um einen vorbestimmten Abstand gleich der Weite der Zellen, die in der Vorrichtung gebildet werden sollen, oder eines ganzzahligen Vielfachen davon, gehen.

15. Gerät nach einem der Ansprüche 9 bis 14, in dem eine Ablagerungsauffangvorrichtung an dem ersten Teil des Prozesskopfs bereitgestellt ist, um Material zu sammeln, das von der Oberseite der Vorrichtung ausgestoßen wird, wenn eine Schneideeinheit an dem zweiten Teil des Prozesskopfs verwendet wird, um einen des ersten, zweiten oder dritten Schnitts zu bilden.

## Revendications

1. Procédé de division d'un dispositif à film mince ayant une première couche qui est une couche d'électrode inférieure, une deuxième couche qui est une couche active et une troisième couche qui est une couche d'électrode supérieure, toutes les couches étant continues sur le dispositif, en cellules distinctes qui sont électriquement interconnectées en série, la division des cellules et la connexion électrique entre des cellules adjacentes étant toutes réalisées en un seul passage d'une tête de traitement sur le dispositif, la tête de traitement comprenant une première partie (20) positionnée au-dessus du dispositif et une deuxième partie (25) positionnée en dessous du dispositif, les première et deuxième parties de la tête de traitement exécutant ensemble les étapes suivantes au cours de l'unique passage :
a) pratiquer une première découpe (6) à travers les première, deuxième et troisième couches ;
b) pratiquer une deuxième découpe (7) à travers les deuxième et troisième couches, la deuxième découpe étant adjacente à la première découpe ;
c) pratiquer une troisième découpe (8) à travers la troisième couche, la troisième découpe étant adjacente à la deuxième découpe et sur le côté opposé de la deuxième découpe à la première découpe ;
d) utiliser une première tête d'impression à jet d'encre (9, 9') dans la première partie (20) de la tête de traitement pour déposer un matériau non conducteur (10) dans la première découpe ; et
e) utiliser une deuxième tête d'impression à jet d'encre (11, 11') sur la première partie (20) de la tête de traitement pour appliquer un matériau conducteur (12) afin de couvrir le matériau non conducteur dans la première découpe et de remplir totalement ou partiellement la deuxième découpe de sorte qu'une connexion électrique soit établie entre la première couche et la troisième couche,
l'étape (a) précédant l'étape (d), l'étape (d) précédant l'étape (e) et l'étape (b) précédant l'étape (e), les étapes pouvant autrement être exécutées dans un ordre quelconque au cours de l'unique passage de la tête de traitement sur le dispositif et au moins l'une des première, deuxième et troisième découpes (6, 7, 8) étant formée à l'aide d'un faisceau laser (3, 4, 5) dirigé depuis la deuxième partie (25) de la tête de traitement vers lesdites première, deuxième et troisième couches à partir du dessous du dispositif.

2. Procédé tel que revendiqué dans la revendication 1, dans lequel l'ordre dans lequel les étapes sont exécutées est déterminé par les positions relatives sur la tête de traitement des première et deuxième têtes d'impression à jet d'encre et de composants sur ladite tête de traitement pour former lesdites première, deuxième et troisième découpes.

3. Procédé tel que revendiqué dans la revendication 1 ou 2, dans lequel au moins deux des première, deuxième et troisième découpes sont formées à l'aide de faisceaux laser.

4. Procédé tel que revendiqué dans la revendication 1, 2 ou 3, dans lequel la première découpe est formée depuis le dessus du dispositif par un moyen de coupe porté par la première partie de la tête de traitement et la deuxième et/ou la troisième découpes sont formées à l'aide de faisceaux laser dirigés depuis la deuxième partie de la tête de traitement vers le dessous du dispositif.

5. Procédé tel que revendiqué dans l'une quelconque des revendications précédentes, dans lequel la tête de traitement est capable d'exécuter toutes lesdites étapes en un seul passage dans l'une ou l'autre des directions ou dans les deux directions sur le dispositif à film mince.

6. Procédé tel que revendiqué dans l'une quelconque des étapes précédentes, dans lequel au moins une étape de durcissement est exécutée au cours dudit unique passage après le dépôt du matériau non conducteur et/ou du matériau conducteur.

7. Procédé tel que revendiqué dans l'une quelconque des revendications précédentes, dans lequel les première et deuxième parties de la tête de traitement sont agencées pour se déplacer d'un seul tenant par rapport au dispositif de sorte que leurs positions relatives l'une par rapport à l'autre soient fixes.

8. Procédé tel que revendiqué dans l'une quelconque des revendications précédentes, dans lequel le dispositif à film mince est l'un des éléments suivants : un panneau solaire, un panneau lumineux et une batterie.

9. Appareil destiné à diviser un dispositif à film mince ayant une première couche qui est une couche d'électrode inférieure, une deuxième couche qui est une couche active et une troisième couche qui est une couche d'électrode supérieure, toutes les couches étant continues sur le dispositif, en cellules distinctes qui sont électriquement interconnectées en série, l'appareil comprenant une tête de traitement ayant une première partie (20) agencée pour être positionnée au-dessus du dispositif et une deuxième partie (25) agencée pour être positionnée en dessous du dispositif, les première et deuxième parties de la tête de traitement étant munie des éléments suivants :
a) au moins une unité de découpe destinée à pratiquer une première découpe à travers les première, deuxième et troisième couches, une deuxième découpe à travers les deuxième et troisième couches adjacente à la première découpe et une troisième découpe à travers la troisième couche adjacente à la deuxième découpe et sur le côté opposé de la deuxième découpe à la première découpe ;
b) une première tête d'impression à jet d'encre (9, 9') destinée à déposer un matériau non conducteur (10) dans la première découpe ; et
c) une deuxième tête d'impression à jet d'encre (11, 11') destinée à appliquer le matériau conducteur dans la première découpe et remplir totalement ou partiellement la deuxième découpe de sorte qu'une connexion électrique soit établie entre la première couche et la troisième couche,
l'appareil comprenant également :
d) un moyen d'entraînement destiné à déplacer la tête de traitement par rapport au dispositif ; et
e) un moyen de commande destiné à commander le déplacement de la tête de traitement par rapport au dispositif et actionner ladite au moins une unité de découpe et lesdites première et deuxième tête d'impression à jet d'encre (9, 9', 11, 11') de sorte que la division du dispositif en cellules distinctes et la formation d'une connexion électrique entre des cellules adjacentes puissent toutes être effectuées en un seul passage de la tête de traitement sur le dispositif, les première et deuxième têtes d'impression à jet d'encre (9, 9', 11, 11') étant prévues sur la première partie (20) de la tête de traitement et agencées pour appliquer un matériau sur un côté supérieur du dispositif et l'au moins une unité de découpe étant prévue sur la deuxième partie (25) de la tête de traitement et agencée pour former au moins l'une des première, deuxième ou troisième découpes au moyen d'un faisceau laser (3, 4, 5) dirigé depuis celle-ci vers lesdites première, deuxième et troisième couches depuis le dessous du dispositif.

10. Appareil tel que revendiqué dans la revendication 9, dans lequel ladite au moins une unité de découpe est prévue que la deuxième partie de la tête de traitement et comprend au moins un laser pulsé destiné à former les première, deuxième et troisième découpes.

11. Appareil tel que revendiqué dans la revendication 9, dans lequel ladite au moins une unité de découpe comprend des lasers pulsés d'au moins deux types destinés à former les première, deuxième et/ou troisième découpes.

12. Appareil tel que revendiqué dans la revendication 9, 10 ou 11, dans lequel les positions relatives sur la tête de traitement des première et deuxième têtes d'impression à jet d'encre et des unités de découpe sur ladite tête de traitement destinées à former lesdites première, deuxième et troisième découpes déterminent l'ordre dans lequel les étapes sont exécutées au cours de l'unique passage de la tête de traitement.

13. Appareil tel que revendiqué dans l'une quelconque des revendications 9 à 12, dans lequel au moins un dispositif de durcissement est prévu sur la première partie de la tête de traitement pour durcir le matériau non conducteur et/ou le matériau conducteur appliqués par les première et/ou deuxième têtes d'impression à jet d'encre au cours de l'unique passage de la tête de traitement.

14. Appareil tel que revendiqué dans l'une quelconque des revendications 9 à 13, dans lequel le système de commande est agencé de sorte que le dispositif et la tête de traitement se déplacent l'un par rapport à l'autre dans une première direction parallèle aux longueurs des première et deuxième découpes sur un trajet continu sur le dispositif et à l'extrémité du trajet pour prendre une direction perpendiculaire à la première direction d'une distance prédéterminée égale à la largeur des cellules à former dans le dispositif ou un multiple entier de celle-ci.

15. Appareil tel que revendiqué dans l'une quelconque des revendications 9 à 14, dans lequel un dispositif de recueil de débris est prévu sur la première partie de la tête de traitement pour recueillir le matériau expulsés depuis le côté supérieur du dispositif lorsqu'une unité de découpe sur la deuxième partie de la tête de traitement est utilisée pour former l'une des première, deuxième ou troisième découpes.
